# EUROPEAN PATENT APPLICATION

(11) **EP 4 709 088 A2**
(43) Date of publication of application: **11.03.2026**
(21) Application number: 25197829.2
(22) Date of filing: 25.08.2025
(51) Int. Cl.: H10D 84/01, H10D 84/83, H10D 84/85, H10D 88/00

(54) **SEMICONDUCTOR DEVICE INCLUDING DIFFERENT TYPES OF FIELD-EFFECT TRANSISTOR**

(30) Priority: 04.09.2024 US 202463690614 P; 11.02.2025 US 202519050814
(71) Applicant: Samsung Electronics Co., Ltd., Suwon-si, Gyeonggi-do 16677 (KR)
(72) Inventor: CHO, Edward Namkyu, Suwon-si, Gyeonggi-do 16677 (KR); PARK, Kibyung, Suwon-si, Gyeonggi-do 16677 (KR); SEO, Junho, Suwon-si, Gyeonggi-do 16677 (KR); SEO, Kang-ill, San Jose, CA 95134 (US)
(74) Representative: Kuhnen & Wacker Patent- und Rechtsanwaltsbüro PartG mbB

(57) **Abstract**

Provided is a semiconductor device which includes: a 1^{st} transistor structure including a 1^{st} n-type field-effect transistor, NFET, and a 1^{st} p-type field-effect transistor, PFET, vertically thereabove, the 1^{st} NFET having a greater channel width than the 1^{st} PFET; and a 2^{nd} transistor structure including a 2^{nd} PFET and a 2^{nd} NFET vertically thereabove, the 2^{nd} PFET having a greater channel width than the 2^{nd} NFET.

## Description

### BACKGROUND

### 1. Field

Apparatuses and methods consistent with the disclosure relate to a semiconductor device in which a plurality of different types of field-effect transistors are formed.

### 2. Description of Related Art

A three-dimensional-stacked (3D-stacked) field-effect transistor (FET) device has been introduced in response to increased demand for an integrated circuit having a high device density and performance. The 3D-stacked FET device may include a 1^{st} FET at a 1^{st} level and a 2^{nd} FET at a 2^{nd} level above the 1^{st} level, where each of the two FETs may be a fin field-effect transistor (FinFET), a nanosheet transistor, a forksheet transistor, or any other type of FET.

The FinFET has one or more fin structures, which are protruded from a substrate, as a channel structure and a gate structure surrounding at least three surfaces of each of the fin structures. The nanosheet transistor is characterized by one or more nanosheet channel layers, which are vertically stacked or arranged on a substrate, as a channel structure and a gate structure surrounding all four surfaces of each of the nanosheet channel layers. The nanosheet transistor is referred to as gate-all-around (GAA) transistor, or as a multi-bridge channel field-effect transistor (MBCFET). The forksheet transistor is a combination of two nanosheet transistors with an isolation wall structure therebetween. In the forksheet transistor, nanosheet channel layers of each nanosheet transistor are formed at each side of an insulation backbone structure and pass through a gate structure in parallel with the isolation wall structure.

As demands for various different types of semiconductor device increase, inventors of the present application have invented a semiconductor device in which a plurality of different types of FET devices including one or more 3D-stacked FET devices are formed.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

The disclosure provides a semiconductor device in which a plurality of different types of FET devices may be formed on one or more base layers, where the different types of FET devices includes a plurality of 3D-stacked FET devices of the same polarity or different polarities.

According to an aspect of the disclosure, there is provided a semiconductor device which may include: a 1^{st} transistor structure including a 1^{st} n-type field-effect transistor (NFET) and a 1^{st} p-type field-effect transistor (PFET) vertically thereabove, the 1^{st} NFET having a greater channel width than the 1^{st} PFET; and a 2^{nd} transistor structure including a 2^{nd} PFET and a 2^{nd} NFET vertically thereabove, the 2^{nd} PFET having a greater channel width than the 2^{nd} NFET.

According to an aspect of the disclosure, there is provided a semiconductor device which may include: a 1^{st} transistor structure including a 1^{st} field-effect transistor (FET) and a 2^{nd} FET vertically above the 1^{st} FET, the 1^{st} FET having a greater channel width than the 2^{nd} FET; and a 2^{nd} transistor structure including a 3^{rd} FET without a transistor vertically thereabove, wherein the 3^{rd} FET is disposed at a side of the 1^{st} FET at a same vertical level.

According to an aspect of the disclosure, there is provided a semiconductor device which may include: a base layer; an FET on the base layer, the FET including a 1^{st} channel structure, a 1^{st} gate structure on the 1^{st} channel structure and a 1^{st} source/drain pattern on the 1^{st} channel structure; and a 2^{nd} gate structure on the 1^{st} gate structure, wherein no channel structure is disposed vertically above the 1^{st} channel structure.

### BRIEF DESCRIPTION OF DRAWINGS

Example embodiments of the disclosure will be more clearly understood from the following detailed description taken in conjunction with the accompanying drawings.
FIGS. 1A-1C illustrate a 3D-stacked field-effect transistor (FET) device in which a p-type field-effect transistor (PFET) is stacked on an n-type field-effect transistor (NFET), according to one or more embodiments.
FIG. 2 illustrates a schematic of an SRAM circuit which can be formed by a semiconductor device including a plurality of different types of FETs.
FIGS. 3A and 3B illustrate an NFET device which can be formed along with the 3D-stacked FET device 10 of FIGS. 1A-1C on the same base layer, according to one or more embodiments.
FIGS. 4A and 4B illustrate a 3D-stacked FET device in which an NFET is stacked on a PFET, according to one or more embodiments.
FIGS. 5A and 5B illustrate a PFET device which can be formed along with the 3D-stacked FET device 40 of FIGS. 4A and 4B on the same base layer, according to one or more embodiments.
FIG. 6A and 6B illustrate a 3D-stacked FET device in which two NFETs are stacked, according to one or more embodiments.
FIG. 7A and 7B illustrate a 3D-stacked FET device in which two PFETs are stacked, according to one or more embodiments.
FIG. 8 illustrates a semiconductor device in which a plurality of different types of FET devices are formed, according to one or more embodiments.
FIG. 9 is a schematic block diagram illustrating an electronic device including one or more semiconductor devices in which a plurality of different types of FET devices are formed, according to one or more embodiments.

### DETAILED DESCRIPTION

All of the embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof. For example, channel layers, sacrificial layers, and isolation layers described herein may take a different type or form as long as the disclosure can be applied thereto.

It will be understood that when an element, component, layer, pattern, structure, region, or so on (hereinafter collectively "element") of a semiconductor device is referred to as being "over," "above," "on," "below," "under," "beneath," "connected to" or "coupled to" another element of the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, an element described as "below" or "beneath" another element would then be oriented "above" the other element. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions herebelow, the "left" element and the "right" element may also be referred to as a "1^{st}" element or a "2^{nd}" element, respectively, as long as their structural relationship is clearly understood in the context of the descriptions. Similarly, the terms a "lower" element and an "upper" element may be respectively referred to as a "1^{st}" element and a "2^{nd}" element with necessary descriptions to distinguish the two elements.

It will be understood that, although the terms "1^{st}," "2^{nd}," "3^{rd}," "4^{th}," "5^{th}," "6^{th}," etc. may be used herein to describe various elements, these elements should not be limited by these terms. These terms are only used to distinguish one element from another element. Thus, a 1^{st} element described in the descriptions of an embodiments could be termed a 2^{nd} element in the descriptions of another element or one or more claims, and vice versa without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" is used to compare a dimension of two or more elements, the term may cover a "substantially same" dimension.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to cross-sectional views that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements, structures or layers of semiconductor devices including a nanosheet transistor and materials forming the same may or may not be described in detail herein. For example, a certain isolation layer or structure of a semiconductor device and materials forming the same may be omitted herein when this layer or structure is not related to the novel features of the embodiments. Also, descriptions of materials forming well-known structural elements of a semiconductor device may be omitted herein when those materials are not relevant to the novel features of the embodiments. Herein, the term "isolation" pertains to electrical insulation or separation between structures, layers, components or regions in a corresponding device or structure.

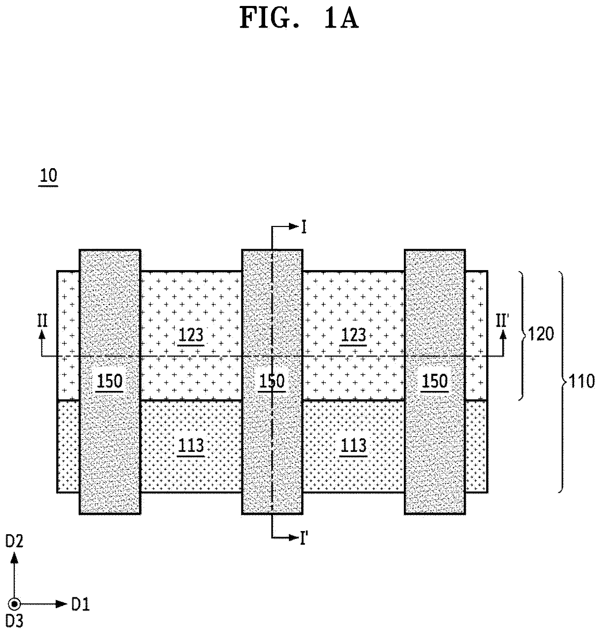

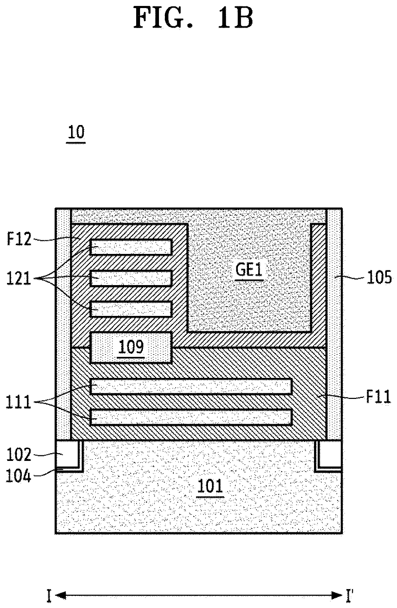

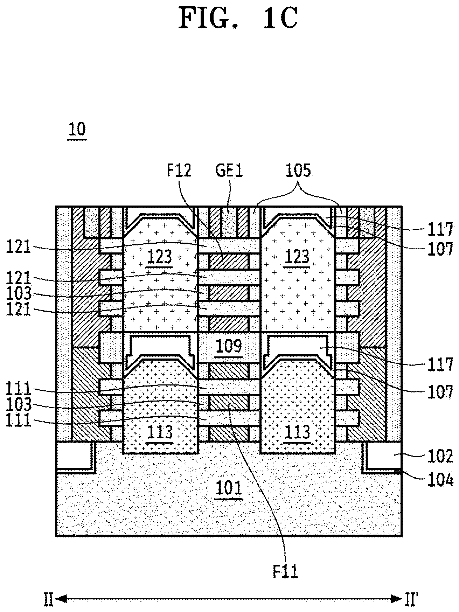

FIGS. 1A-1C illustrate a 3D-stacked field-effect transistor (FET) device in which a p-type field-effect transistor (PFET) is stacked on an n-type field-effect transistor (NFET), according to one or more embodiments. FIG. 1A is a plan view of the 3D-stacked FET device, and FIGS. 1B and 1C are cross-section views of the 3D-stacked FET device shown in FIG. 1A taken along lines I-I' and II-II' respectively.

It is to be understood here that FIG. 1A is provided to show positional relationships between structural elements of the 3D-stacked FET device, and thus, shapes of these structural elements may differ from those in the rest of the drawings and some of the structural elements may not be shown therein.

Referring to FIGS. 1A-1C, a 3D-stacked FET device 10 may be formed based on a 1^{st} active pattern 110 and a 2^{nd} active pattern 120 extended in a D1 direction and a plurality of gate structures 150 arranged in the D1 direction and extended in a D2 direction intersecting the D1 direction. It is to be understood that although only three gate structures 150 are shown in FIG. 1A, one or more gate structures may be arranged at a left side and/or a right side of the three gate structures 150 to form the 3D-stacked FET device 10.

The 1^{st} active pattern 110 may be formed on a base layer 101, and the 2^{nd} active pattern 120 may be stacked on the 1^{st} active pattern 110. The 1^{st} active pattern 110 may have a greater width than the 2^{nd} active pattern 120 in the D2 direction, and thus, the 2^{nd} active pattern 120 stacked on the 1^{st} active pattern 110 may partially overlap the 1^{st} active pattern 110 in a D3 direction intersecting the D1 direction and the D2 direction.

The 1^{st} active pattern 110 may form a 1^{st} channel structure 111 and 1^{st} source/drain patterns 113 for an NFET at a 1^{st} level of the 3D-stacked FET device 10. The 1^{st} channel structure 111 may be formed of a plurality of 1^{st} nanosheet layers epitaxially grown from the base layer 101, which may be a silicon (Si)-based substrate, and thus, the 1^{st} nanosheet layers may also be formed of silicon. The 1^{st} source/drain patterns 113 of n-type may be epitaxially grown from the 1^{st} nanosheet layers of the 1^{st} channel structure 111, and may be formed of silicon doped with n-type impurities (e.g., phosphorus, arsenic, or antimony). The 1^{st} channel structure 111 may be surrounded by the gate structure 150 which controls current flow between the 1^{st} source/drain patterns 113 through the 1^{st} channel structure 111. The gate structure 150 may include a 1^{st} work-function metal layer F11 of n-type surrounding each of the 1^{st} nanosheet layers and a gate electrode GE1 formed on the 1^{st} work-function metal layer F11. A gate dielectric layer may be formed between the 1^{st} work-function metal layer F11 and the 1^{st} nanosheet layers. The 1^{st} work-function metal layer F11 may be formed of, for example, titanium aluminum carbide (TiAlC), not being limited thereto, and the gate electrode GE1 may be formed of a metal, for example, tungsten (W), aluminum (Al), copper (Cu), etc., or a metal compound, not being limited thereto. The 1^{st} channel structure 111 including the 1^{st} nanosheet layers, the 1^{st} source/drain patterns 113 and the gate structure 150 including the 1^{st} work-function metal layer F11 may form an NFET implemented by a nanosheet transistor at the 1^{st} level of the 3D-stacked FET device 10.

The 2^{nd} active pattern 120 may form a 2^{nd} channel structure 121 and 2^{nd} source/drain patterns 123 for a PFET at a 2^{nd} level above the 1^{st} level in the D3 direction. The 2^{nd} channel structure 121 may be formed of a plurality of 2^{nd} nanosheet layers also epitaxially grown from the base layer 101, which may be a silicon-based substrate, and thus, the 2^{nd} nanosheet layers may also be formed of silicon. The 2^{nd} source/drain patterns 123 may be epitaxially grown from the 2^{nd} nanosheet layers of the 2^{nd} channel structure 121, and may be formed of silicon germanium (SiGe) doped with p-type impurities (e.g., boron, gallium, or indium). The 2^{nd} channel structure 121 may also be surrounded by the gate structure 150 which controls current flow between the 2^{nd} source/drain patterns 123 through the 2^{nd} channel structure 121. The 2^{nd} nanosheet layers forming the 2^{nd} channel structure 121 may be surrounded by a 2^{nd} work-function metal layer F12 of p-type on which the gate electrode GE1 is formed. The 2^{nd} work-function metal layer F12 may be formed of, for example, titanium nitride (TiN), not being limited thereto. The gate dielectric layer may also be formed between the 2^{nd} work-function metal layer F12 and the 2^{nd} nanosheet layers. The 2^{nd} channel structure 121 including the 2^{nd} nanosheet layers, the 2^{nd} source/drain patterns 123 and the gate structure 150 including the 2^{nd} work-function metal layer F12 may form a PFET implemented by a nanosheet transistor at the 2^{nd} level of the 3D-stacked FET device 10.

It is to be understood here that the D1 direction is a channel-length direction in which a current flows between two source/drain patterns connected to each other through a channel structure, the D2 direction is a channel-width direction or a cell-height direction that horizontally intersects the D1 direction, and the D3 direction is a channel-thickness direction. The D1 and D2 directions may each be referred to as a horizontal direction and the D3 direction may be referred to as a vertical direction.

FIGS. 1A and 1B show that the 2^{nd} nanosheet layers forming the 2^{nd} channel structure 121 may have a smaller width in the D2 direction than the 1^{st} nanosheet layers forming the 1^{st} channel structure 111, and thus, the 2^{nd} channel structure 121 stacked on the 1^{st} channel structure 111 may partially overlap the 1^{st} channel structure 111 in the D3 direction. For example, left side surfaces of the 2^{nd} nanosheet layers may aligned or coplanar with left side surfaces of the 1^{st} nanosheet layers in the D3 direction, while right side surfaces of the 2^{nd} nanosheet layers are not aligned or coplanar with right side surfaces of the 1^{st} nanosheet layers in the D3 direction. Thus, the 2^{nd} source/drain patterns 123 epitaxially grown from the 2^{nd} nanosheet layers may also be formed to have a smaller width in the D2 direction than the 1^{st} source/drain patterns 113 epitaxially grown from the 1^{st} nanosheet layers. This width difference provides a space above a top surface of each of the 1^{st} source/drain patterns 113 which is not vertically overlapped by the 2^{nd} source/drain pattern 123 so that a source/drain contact structure may be formed through this space to contact the top surface of the 1^{st} source/drain pattern 113. The foregoing characteristics of the channel structures and the source/drain patterns may be provided to address increasing demands for a high device density in a semiconductor device including 3D-stacked FET devices.

Instead, the 2^{nd} channel structure 121 forming the PFET may have a greater number of nanosheet layers than the 1^{st} channel structure 111 forming the NFET so that the two field-effect transistors (FETs) may have the same or substantially same effective channel width (W_{eff}). For example, the 2^{nd} channel structure 121 may have three nanosheet layers while the 1^{st} channel structure 111 may have two nanosheet layers.

The different channel widths and the different number of nanosheet layers, that is, channel layers, may facilitate optimization of a 3D-stacked FET device in terms of not only area gain for a high-density integrated circuit but also device performance such as current speed, work load distribution, power efficiency, contact resistance, thermal control, structural stability, etc.

Referring to FIG. 1C, the 3D-stacked FET device 10 may also include inner spacers 103 formed between each of the source/drain patterns 113 and 123 and the gate structure 150 including the work-function metal layers F11 and F12. The inner spacers 103 may each be formed of a material such as silicon nitride (e.g., SiN, Si₃N₄) or silicon oxide (e.g., SiO₂), not being limited thereto, to isolate the source/drain patterns 113 and 123 from the gate structure 150.

The 3D-stacked FET device 10 may also include gate spacers 105 formed on respective side surfaces of the gate structures 150. The gate spacers 105 may prevent current leakage from the gate structure 150 to other circuit elements. The gate spacer 105 may be formed of silicon oxide (e.g., SiO₂) or silicon nitride (e.g., SiN or Si₃N₄), not being limited thereto, which may be the same as or different from the material(s) forming the inner spacers 103.

Each of the source/drain patterns 113 and 123 may include a protection layer 107 on a top surface and/or a bottom surface thereof. The protection layer 107 may protect these active structures from various operations during the processes of manufacturing the 3D-stacked FET device 10. The protection layer 107 may extend along a side surface of the gate structure 150. The protection layer 107 may also be formed of a material such as silicon nitride (e.g., SiN or Si₃N₄), SiBCN, SiCN, SiOC, or SiOCN, not being limited thereto. A middle isolation layer 109 may be formed between the 1^{st} work-function metal layer F11 and the 2^{nd} work-function metal layer F12. The middle isolation layer 109 may also be formed of a material such as silicon nitride (e.g., SiN or Si₃N₄), SiBCN, SiCN, SiOC, or SiOCN, not being limited thereto.

A shallow trench isolation (STI) structure 102 may be formed at a side of an active region which is a protruded portion of the base layer 101 which may be a silicon-based substrate. The STI structure 102 may be formed of a low-k dielectric material such as silicon oxide (e.g., SiO₂) or silicon nitride (e.g., SiN or Si₃N₄), not being limited thereto. The STI structure 102 may isolate the 3D-stacked FET device 10 from another semiconductor device. An STI liner 104 including silicon nitride (e.g., SiN or Si₃N₄) may be formed between the STI structure 102 and the base layer 101 to prevent oxidation of the base layer 101 in case the base layer 101 is a silicon-based substrate.

An isolation structure 117 may be formed to surround the source/drain patterns 113 and 123 to isolate these two active structures from each other or from other circuit elements. The isolation structure 117 may be formed of, for example, a low-k dielectric material such as silicon oxide (e.g., SiO₂), not being limited thereto.

In the above embodiments, the 3D-stacked FET device 10 may be formed on the base layer 101 which may be a silicon-based substrate. However, the disclosure is not limited thereto, and, according to one or more other embodiments, the base layer 101 may be or include a backside isolation layer formed of a low-k dielectric material such as silicon oxide (e.g., SiO₂), which has at least partially replaced an original silicon substrate in a later step of manufacturing the 3D-stacked FET device 10 so that a backside metal contact structure may be formed therein to connect at least one of the 1^{st} source/drain patterns 113 or the gate structure 150 to a voltage source or another circuit element.

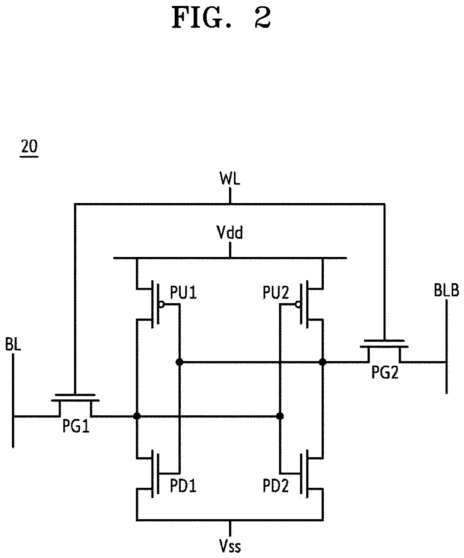

In the meantime, the 3D-stacked FET device 10 including the NFET and the PFET stacked thereon as described above may form a complementary metal-oxide-semiconductor (CMOS) device for an inverter circuit which is an essential circuit element of semiconductor devices. For example, a CMOS device may form a set of a pull-down transistor and a pull-up transistor in a static random access memory (SRAM) circuit as shown in FIG. 2, according to one or more embodiments.

FIG. 2 illustrates a schematic of an SRAM circuit which can be formed by a semiconductor device including a plurality of different types of FET.

Referring to FIG. 2, an SRAM circuit 20 may be made up of six FETs including pull-up transistors PU1 and PU2 powered by a positive voltage source VDD, pull-down transistors PD1 and PD2 powered by a negative voltage source VSS or ground, and pass-gate transistors PG1 and PG2. Each bit in the SRAM is stored on the four transistors PU1, PD1, PU2 and PD2 that form two cross-coupled inverters. Here, the pull-up transistor PU1 and the pull-down transistor PD1 may form an inverter implemented by a 3D-stacked FET device including an NFET (PD1) and a PFET (PU1) stacked thereon, and the pull-up transistor PU2 and the pull-down transistor PD2 may form another inverter implemented by another 3D-stacked FET device including an NFET (PD2) and a PFET (PU2) stacked thereon. Two pass-gate transistors PG1 and PG2 each of which is an NFET device may serve to control an access to the memory cell (i.e., the two cross-coupled inverters) during read and write operations of the SRAM circuit 20 by being connected to a word line WL, a bit line BL and a complementary bit line BLB.

This six-transistor (6T) SRAM circuit 20 shown in FIG. 2 may be implemented in a standard cell and may be manufactured by forming two of the 3D-stacked FET device 10 shown in FIGS. 1A-1C as the two cross-coupled inverters (PD1/PU1 and PD2/PU2), and forming two NFET devices as the pass-gate transistors PG1 and PG2. Here, two 3D-stacked FET devices for the two cross-coupled inverters and two NFET devices for the pass-gate transistors PG1 and PG2 may be formed on the same single base layer 101 of the 3D-stacked FET device 10 which may be a silicon-based substrate and/or a backside isolation structure as described earlier.

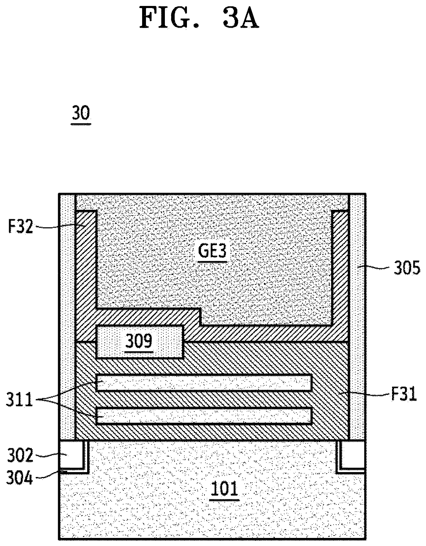

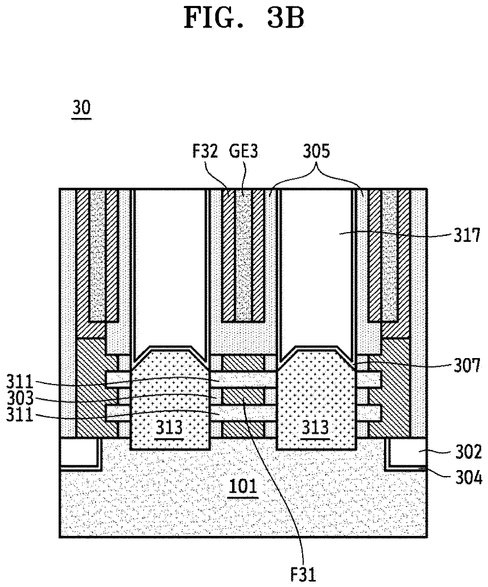

FIGS. 3A and 3B illustrate an NFET device which can be formed along with the 3D-stacked FET device 10 of FIGS. 1A-1C on the same base layer 101, according to one or more embodiments.

FIGS. 3A and 3B are cross-section views of an NFET device 30 taken along lines analogous to the respective lines I-I' and II-II' shown in FIG. 1A. The NFET device 30 may include an NFET formed of a 1^{st} channel structure 311, a gate structure, and 1^{st} source/drain patterns 313 on the same base layer 101 on which the 3D-stacked FET device 10 of FIG. 1A-1C is formed. However, unlike in the 3D-stacked FET device 10, no PFET may be stacked on the NFET in the NFET device 30 as shown in FIGS. 3A and 3B.

The 1^{st} channel structure 311 of the NFET device 30 may include a plurality of 1^{st} nanosheet layers which may be epitaxially grown from the same base layer 101 (silicon-based substrate) from which the nanosheet layers of the channel structures 111 and 121 of the 3D-stacked FET device 10 may also be epitaxially grown. For example, the 1^{st} nanosheet layers of the 1^{st} channel structure 311 and the 1^{st} nanosheet layers of the 1^{st} channel structure 111 may be a same structure on the base layer 101 and may be separated to form respective channel structures 111 and 311 of the different transistor structures when the 3D-stacked FET device 10 and the NFET device 30 are manufactured. Thus, the 1^{st} nanosheet layers of the 1^{st} channel structure 311 of the NFET device 30 and the 1^{st} nanosheet layers of the 1^{st} channel structure 111 of the FET device 10 may be at the same levels in the D3 direction, respectively.

In manufacturing the NFET device 30, a plurality of 2^{nd} nanosheet layers, which are a same structure of the 2^{nd} nanosheet layers of the 2^{nd} channel structure 121 of the 3D-stacked FET device 10, may also be formed from the base layer 101 as an upper channel structure stacked on the channel structure 311. However, these 2^{nd} nanosheet layers to form the upper channel structure may be removed to leave only the 1^{st} nanosheet layers for the channel structure 311 as the channel structure of the NFET device 30. Accordingly, the NFET device 30 may include only the 1^{st} source/drain patterns 313 epitaxially grown from the 1^{st} nanosheet layers of the 1^{st} channel structure 311, without 2^{nd} source/drain patterns thereabove. The 1^{st} source/drain patterns 313 may be of the same n-type formed of the same materials as the 1^{st} source/drain patterns 113 of the 3D-stacked FET device 10, for example, silicon (Si) with n-type impurities such as phosphorus, arsenic, antimony, etc.

A gate structure surrounding the 1^{st} nanosheet layers of the channel structure 311 may be one of those three gate structures 150 shown in FIG. 1A or another gate structure arranged at a side of thereof. This gate structure of the NFET device 30 may be formed of a 1^{st} work-function metal layer F31 and a gate electrode GE3 which correspond to the 1^{st} work-function metal layer F11 and the gate electrode GE1 of the 3D-stacked FET 10 of FIGS. 1A-1C. A top surface of the gate electrode GE3 and a top surface of the gate electrode GE1 may be disposed at a same vertical level in the D3 direction. The 1^{st} work-function metal layer F31 may be formed at the same time as the 1^{st} work-function metal layer F11 for the NFET of the 3D-stacked FET device 10 in a single process as an extension of the 1^{st} work-function metal layer F11. Thus, the 1^{st} work-function metal layer F31 may be formed of the same n-type material as the 1^{st} work-function metal layer F11 of the 3D-stacked FET device 10, for example, titanium aluminum carbide (TiAlC), not being limited thereto.

However, as described above, no transistor such as the PFET stacked on the NFET in the 3D-stacked FET 10 of FIGS. 1A-1C may be formed on the NFET of the NFET device 30. Thus, the NFET device 30 may be formed of only the NFET at the 1^{st} level without a 2^{nd} channel structure and 2^{nd} source/drain patterns for a PFET at the 2^{nd} level. However, a 2^{nd} work-function metal layer F32 may be formed as an extension of the 2^{nd} work-function metal layer F12 for the PFET of the 3D-stacked FET device 10 when the NFET device 30 is manufactured along with the 3D-stacked FET device 10 on the base layer 101. For example, when the 2^{nd} work-function metal layer F12 for the PFET of the 3D-stacked FET device 10 is formed, an extension of this 2^{nd} work-function metal layer F12 may form the 2^{nd} work-function metal layer F32 on a top surface of the 1^{st} work-function metal layer F31 and respective side surfaces of gate spacers 305 which may be an extension of the gate spacers 105 of the 3D-stacked FET device 10. However, according to one or more other embodiments, the 2^{nd} work-function metal layer F32 may not be formed when the NFET device 30 is formed along with the 3D-stacked FET 10.

The NFET device 30 may also include a middle isolation layer 309 formed between the 1^{st} work-function metal layer F31 and the 2^{nd} work-function metal layer F32, if any. The middle isolation layer 309 may also be formed at the same time as the middle isolation layer 109 is formed for the 3D-stacked FET device 10 as an extension thereof in a single process. Further, an STI structure 302, an STI liner 304, inner spacers 303, gate spacers 305, a protection layer 307, and an isolation structure 317 may also be formed in the NFET device 30 as extensions of the corresponding structures, respectively, of the 3D-stacked FET device 10, in respective single processes.

Thus, an SRAM circuit as shown in FIG. 2 may be formed by a semiconductor device in which two 3D-stacked FET devices 10, each of which is a CMOS device, as shown in FIGS. 1A-1C, and two NFET devices 30 as shown in FIGS. 3A and 3B are formed on the same base layer 101. Here, as each of the two 3D-stacked FET devices 10 for the cross-coupled inverters has an NFET at the 1^{st} level, an NFET of each of the NFET devices 30 for the pass-gate transistors may be formed based on the same base layer 101. For example, the NFETs of the two NFET devices 30 each including the channel structures 311 and the source/drain patterns 313 may be formed at the same time as the NFETs of the two 3D-stacked FET devices 10 including the 1^{st} channel structures 111 and the 1^{st} source/drain patterns 113 in a single process, based on the same base layer 101.

However, one or more of the 3D-stacked FET device 10 and the NFET device 30 may form a plurality of different types of semiconductor devices, other than the SRAM circuit 20 as shown in FIG. 2, according to one or more other embodiments. Further, the structure of a 3D-stacked FET device or an FET device forming a semiconductor device is not limited to those described in the above embodiments. A plurality of different types of 3D-stacked FET devices and/or NFET devices may be formed or combined to form a semiconductor device, as described herebelow.

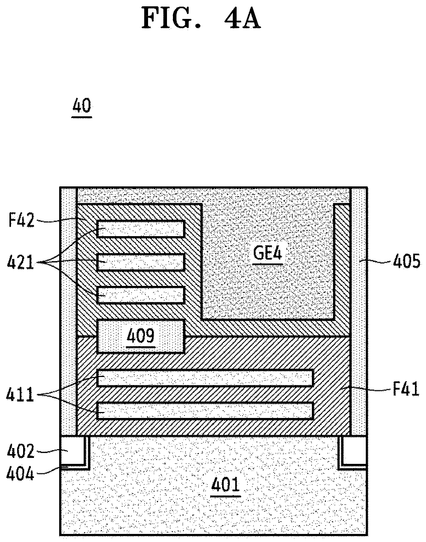

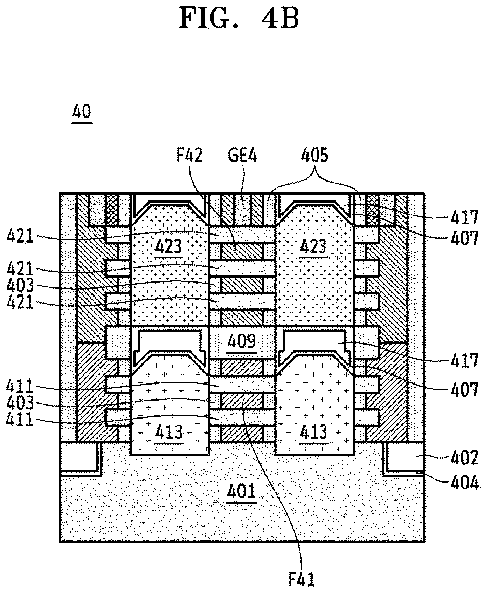

FIGS. 4A and 4B illustrate a 3D-stacked FET device in which an NFET is stacked on a PFET according to one or more embodiments.

Referring to FIGS. 4A and 4B are cross-section views of a 3D-stacked FET device 40 taken along lines analogous to the respective lines I-I' and II-II' shown in FIG. 1A. The 3D-stacked FET device 40 may be formed of a PFET at the 1^{st} level and an NFET at the 2^{nd} level above the 1^{st} level, unlike in the 3D-stacked FET device 10. Each of the PFET and the NFET of the 3D-stacked FET device 40 may also be implemented by a nanosheet transistor as in the 3D-stacked FET device 10 shown in FIGS. 1A-1C. Thus, duplicate descriptions thereof may be omitted herein, and instead, different aspects of the 3D-stacked FET device 40 may be described herebelow.

Similar to the 3D-stacked FET device 10 of FIGS. 1A-1C, the 3D-stacked FET device 40 of FIGS. 4A and 4B may also include a base layer 401, a 1^{st} channel structure 411, a 2^{nd} channel structure 421, a gate structure including a 1^{st} work-function metal layer F41, a 2^{nd} work-function metal layer F42 and a gate electrode GE4, 1^{st} source/drain patterns 413, 2^{nd} source/drain patterns 423, an STI structure 402, an STI liner 404, inner spacers 403, gate spacers 405, a protection layer 407, a middle isolation layer 409, and an isolation structure 417 which have the same or similar structures as the corresponding ones of the 3D-stacked FET device 10.

However, as described above, the 1^{st} channel structure 411, the gate structure including the 1^{st} work-function metal layer F41 and the gate electrode GE4, and the 1^{st} source/drain patterns 413 at the 1^{st} level may form a PFET, and the 2^{nd} channel structure 421, the gate structure including the 2^{nd} work-function metal layer F42 and the gate electrode GE4, and the 2^{nd} source/drain patterns 423 at the 2^{nd} level may form an NFET. Thus, the 3D-stacked FET device 40 may differ from the 3D-stacked FET device 10 shown in FIGS. 1A-1C only by the device polarity while these two FET devices have the same structural shape. For example, the 1^{st} source/drain patterns 413 and the 1^{st} work-function metal layer F41 of the 3D-stacked FET device 40 may be formed of the same p-type materials as those of the 2^{nd} source/drain patterns 123 and the 2^{nd} work-function metal layer F12 of the 3D-stacked FET device 10, while the 2^{nd} source/drain patterns 423 and the 2^{nd} work-function metal layer F42 of the 3D-stacked FET device 40 may be formed of the same n-type materials as those of the 1^{st} source/drain patterns 113 and the 1^{st} work-function metal layer F11 of the 3D-stacked FET device 10, respectively.

Like, the 3D-stacked FET device 10, the 3D-stacked FET device 40 may also form a plurality of different types of semiconductor devices, according to one or more embodiments. For example, the 3D-stacked FET device 40 may form a CMOS device such as an inverter implementing the pull-up transistor PU1 (or PU2) and the pull-down transistor PD1 (or PD2) of the SRAM circuit 20 of FIG. 2, according to one or more embodiments.

When the 3D-stacked FET device 40 is formed to have a PFET at the 1^{st} level, an NFET at the 2^{nd} level may not be formed at the same time as the NFET of the NFET device 30 for a pass-gate transistor based on a same base layer in a single process. However, the PFET at the 1^{st} level may enable improved channel stress control and current leakage prevention for the 3D-stacked FET device 40.

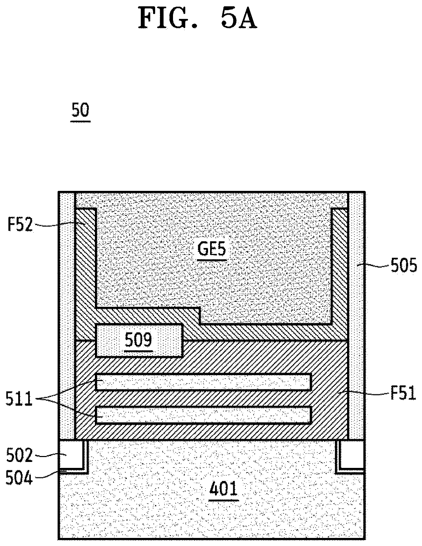

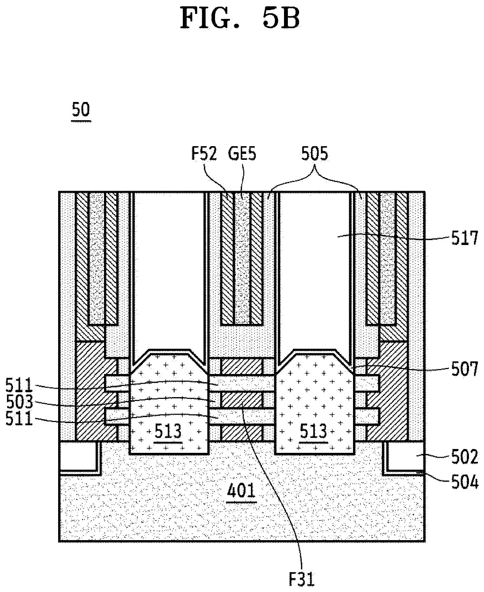

FIGS. 5A and 5B illustrate a PFET device which can be formed along with the 3D-stacked FET device 40 of FIGS. 4A and 4B on the same base layer, according to one or more embodiments.

Referring to FIGS. 5A and 5B are cross-section views of a PFET device 50 taken along lines analogous to the respective lines I-I' and II-II' shown in FIG. 1A. The PFET device 50 may include a PFET formed of a 1^{st} channel structure 511, a gate structure, and 1^{st} source/drain patterns 513 on the same base layer 401 on which the 3D-stacked FET device 40 of FIG. 4A and 4B is formed. However, unlike in the 3D-stacked FET device 40, no NFET may be stacked on the PFET in the PFET device 50 as shown in FIGS. 5A and 5B. The PFET device 50 may differ from the NFET device 30 shown in FIGS. 3A and 3B only by the device polarity while the two devices have the same structural shape.

The 1^{st} channel structure 511 of the PFET device 50 may include a plurality of 1^{st} nanosheet layers which may be epitaxially grown from the base layer 401 (silicon-based substrate) from which the nanosheet layers of the channel structures 411 and 421 of the 3D-stacked FET device 40 may also be epitaxially grown. For example, the 1^{st} nanosheet layers of the 1^{st} channel structure 511 and the 1^{st} nanosheet layers of the 1^{st} channel structure 411 may be a same structure on the base layer 401 before they are separated to form respective channel structures 411 and 511 of the different transistor structures when the 3D-stacked FET device 40 and the PFET device 50 are manufactured. Thus, the 1^{st} nanosheet layers of the 1^{st} channel structure 511 of the PFET device 50 and the 1^{st} nanosheet layers of the 1^{st} channel structure 411 of the FET device 40 may be at the same levels in the D3 direction, respectively.

In manufacturing the PFET device 50, a plurality of 2^{nd} nanosheet layers, which are a same structure of the 2^{nd} nanosheet layers of the 2^{nd} channel structure 421 of the 3D-stacked FET device 40, may also be formed from the base layer 401 as an upper channel structure stacked on the channel structure 511. However, these 2^{nd} nanosheet layers to form the upper channel structure may be removed to leave only the 1^{st} nanosheet layers for the channel structure 511 as the channel structure of the PFET device 50. Accordingly, the PFET device 50 may include only the 1^{st} source/drain patterns 513 epitaxially grown from the 1^{st} nanosheet layers of the 1^{st} channel structure 511, without 2^{nd} source/drain patterns thereabove. The 1^{st} source/drain patterns 513 may be formed of the same p-type materials as those of the 1^{st} source/drain patterns 413 of the 3D-stacked FET device 40, for example, silicon germanium (SiGe) with p-type impurities such as boron, gallium, or indium, etc.

A gate structure surrounding the 1^{st} nanosheet layers of the channel structure 511 may be at a side of the gate structure of the 3D-stacked FET device 40 in the D2 direction. This gate structure of the PFET device 50 may be formed of a 1^{st} work-function metal layer F51 and a gate electrode GE5 which correspond to the 1^{st} work-function metal layer F41 and the gate electrode GE4 of the 3D-stacked FET 40 of FIGS. 4A and 4B. A top surface of the gate electrode GE5 and a top surface of the gate electrode GE4 may be disposed at a same vertical level in the D3 direction. The 1^{st} work-function metal layer F51 may be formed at the same time as the 1^{st} work-function metal layer F41 for the PFET of the 3D-stacked FET device 40 in a single process as an extension of the 1^{st} work-function metal layer F41. Thus, the 1^{st} work-function metal layer F51 may be formed of the same p-type material as those of the 1^{st} work-function metal layer F41 of the 3D-stacked FET device 40, for example, titanium nitride (TiN), not being limited thereto.

However, as described above, no transistor such as the NFET stacked on the PFET in the 3D-stacked FET 40 of FIGS. 4A and 4B may be formed on the PFET of the PFET device 50. Thus, the PFET device 50 may be formed of only the PFET at the 1^{st} level without a 2^{nd} channel structure and 2^{nd} source/drain patterns for an NFET at the 2^{nd} level. However, a 2^{nd} work-function metal layer F52 may be formed as an extension of the 2^{nd} work-function metal layer F42 for the NFET of the 3D-stacked FET device 40 when the PFET device 50 is manufactured along with the 3D-stacked FET device 40 on the base layer 401. For example, when the 2^{nd} work-function metal layer F42 for the NFET of the 3D-stacked FET device 40 is formed, an extension of this 2^{nd} work-function metal layer F42 may form the 2^{nd} work-function metal layer F52 on a top surface of the 1^{st} work-function metal layer F51 and respective side surfaces of gate spacers 505 which may be an extension of the gate spacers 405 of the 3D-stacked FET device 40. However, according to one or more other embodiments, the 2^{nd} work-function metal layer F52 may not be formed when the PFET device 50 is formed along with the 3D-stacked FET 40.

The PFET device 50 may also include a middle isolation layer 509 formed between the 1^{st} work-function metal layer F51 and the 2^{nd} work-function metal layer F52, if any. The middle isolation layer 509 may also be formed at the same time as the middle isolation layer 409 is formed for the 3D-stacked FET device 40 as an extension thereof in a single process. Further, an STI structure 502, an STI liner 504, inner spacers 503, gate spacers 505, a protection layer 507, and an isolation structure 517 may also be formed in the PFET device 50 as extensions of the corresponding structures, respectively, of the 3D-stacked FET device 40, in respective single processes.

The PFET device 50 including only the PFET at the 1^{st} level may also form a semiconductor device along with one or more of the 3D-stacked FET device 10 of FIGS. 1A-1C and 3D-stacked FET device 40 of FIGS. 4A and 4B, and the NFET device 30 of FIGS. 3A and 3B, according to one or more embodiments.

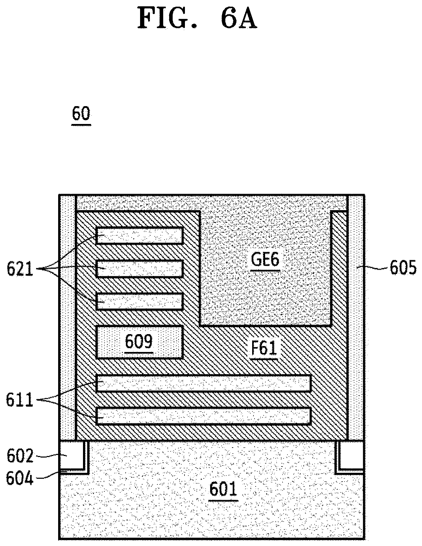

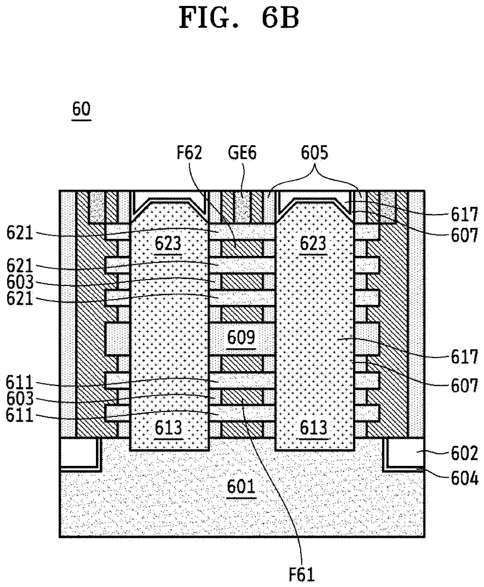

FIG. 6A and 6B illustrate a 3D-stacked FET device in which two NFETs are stacked according to one or more embodiments.

Referring to FIGS. 6A and 6B are cross-section views of a 3D-stacked FET device 60 taken along lines analogous to the respective lines I-I' and II-II' shown in FIG. 1A. The 3D-stacked FET device 60 may be formed of an NFET at the 1^{st} level and another NFET at the 2^{nd} level above the 1^{st} level, unlike in the 3D-stacked FET device 10 formed of two FETs of different polarities at the 1^{st} level and the 2^{nd} level, respectively. Each of the two NFETs of the 3D-stacked FET device 60 may also be implemented by a nanosheet transistor as in the 3D-stacked FET device 10 shown in FIGS. 1A-1C. Thus, duplicate descriptions thereof may be omitted herein, and instead, different aspects of the 3D-stacked FET device 60 may be described herebelow.

Similar to the 3D-stacked FET device 10 of FIGS. 1A-1C, the 3D-stacked FET device 60 of FIGS. 6A and 6B may also include a base layer 601, a 1^{st} channel structure 611, a 2^{nd} channel structure 621, 1^{st} source/drain patterns 613, 2^{nd} source/drain patterns 623, an STI structure 602, an STI liner 604, inner spacers 603, gate spacers 605, a protection layer 607, a middle isolation layer 609, and an isolation structure 617 which have the same or similar structures as the corresponding ones of the 3D-stacked FET device 10.

However, as described above, the two FETs at the 1^{st} level and the 2^{nd} level in the 3D-stacked FET device 60 are of n-type. Thus, a gate structure of the 3D-stacked FET device 60 may include only a 1^{st} work-function metal layer F61 of n-type without a 2^{nd} work-function metal layer of p-type, and this 1^{st} work-function metal layer F61 may surround both the 1^{st} channel structure 611 and the 2^{nd} channel structure 621 in the 3D-stacked FET device 60. Like the 1^{st} work-function metal layer F11 of the 3D-stacked FET device 10, the 1^{st} work-function metal layer F61 may be formed of, for example, titanium aluminum carbide (TiAlC), not being limited thereto. Further, the source/drain patterns 613 and 623 may both be formed of the same n-type materials forming the 1^{st} source/drain patterns 113 of the 3D-stacked FET device 10, for example, silicon (Si) with n-type impurities such as phosphorus (P), arsenic (As), antimony (Sb), etc.

In the meantime, the 1^{st} source/drain patterns 613 and the 2^{nd} source/drain patterns 623 may be formed from the nanosheet layers of the 1^{st} channel structure 611 and the 2^{nd} channel structure 621 at the same time in a single process, and thus, a 1^{st} source/drain pattern 613 and a 2^{nd} source/drain pattern 623 thereabove may be merged as shown in FIG. 6B during an epitaxial growth process based on the two channel structures 611 and 621. As the two n-type source/drain patterns 613 and 623 are merged, an amount and mobility of electrons for current flow may increase to improve performance of the 3D-stacked FET device 60 as an NFET device. However, the disclosure is not limited thereto, and, according to one or more other embodiments, the 1^{st} source/drain pattern 613 and the 2^{nd} source/drain pattern 623 thereabove may be formed at different times to be separated from each other.

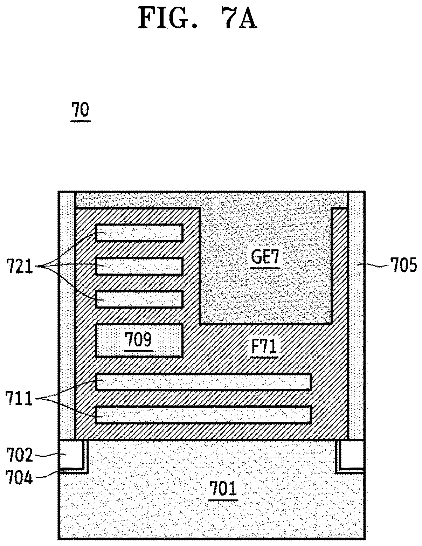

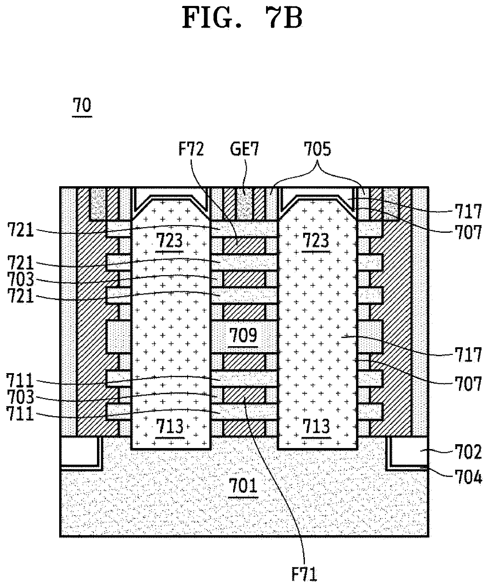

FIG. 7A and 7B illustrate a 3D-stacked FET device in which two PFETs are stacked according to one or more embodiments.

Referring to FIGS. 7A and 7B are cross-section views of a 3D-stacked FET device 70 taken along lines analogous to the respective lines I-I' and II-II' shown in FIG. 1A. The 3D-stacked FET device 70 may be formed of a PFET at the 1^{st} level and another PFET at the 2^{nd} level above the 1^{st} level, opposite the 3D-stacked FET device 60 formed of two NFETs at the 1^{st} level and the 2^{nd} level, respectively, in terms of device polarity. Each of the two PFETs of the 3D-stacked FET device 70 may also be implemented by a nanosheet transistor as in the 3D-stacked FET device 60. Thus, duplicate descriptions thereof may be omitted herein, and instead, different aspects of the 3D-stacked FET device 70 may be described herebelow.

Similar to the 3D-stacked FET device 60 of FIGS. 6A and 6B, the 3D-stacked FET device 70 of FIGS. 7A and 7B may also include a base layer 701, a 1^{st} channel structure 711, a 2^{nd} channel structure 721, a 1^{st} work-function metal layer F71, 1^{st} source/drain patterns 713, 2^{nd} source/drain patterns 723, an STI structure 702, an STI liner 704, inner spacers 703, gate spacers 705, a protection layer 707, a middle isolation layer 709, and an isolation structure 717 which have the same or similar structures as the corresponding ones of the 3D-stacked FET device 60.

However, as described above, the two FETs at the 1^{st} level and the 2^{nd} level in the 3D-stacked FET device 70 are of p-type. Thus, a gate structure of the 3D-stacked FET device 70 may include only a 1^{st} work-function metal layer F71 of p-type without a 2^{nd} work-function metal layer of n-type, and this 1^{st} work-function metal layer F71 may surround both the 1^{st} channel structure 711 and the 2^{nd} channel structure 721 in the 3D-stacked FET device 70. Like the 2^{nd} work-function metal layer F12 of the 3D-stacked FET device 10, the 1^{st} work-function metal layer F71 may be formed of, for example, titanium nitride (TiN), not being limited thereto. Further, the source/drain patterns 713 and 723 may both be of p-type and formed of, for example, silicon germanium (SiGe) doped with p-type impurities (e.g., boron, gallium, or indium).

Similar to the source/drain patterns 613 and 623 of the 3D-stacked FET device 60, the 1^{st} source/drain patterns 713 and the 2^{nd} source/drain patterns 723 may be formed from the nanosheet layers of the 1^{st} channel structure 711 and the 2^{nd} channel structure 721 at the same time in a single process, and thus, a 1^{st} source/drain pattern 713 and a 2^{nd} source/drain pattern 723 thereabove may be merged as shown in FIG. 7B during an epitaxial growth process based on the two channel structures 711 and 721. As the two p-type source/drain patterns 713 and 723 are merged, an amount and mobility of holes for current flow may increase to improve performance of the 3D-stacked FET device 70 as a PFET device. However, the disclosure is not limited thereto, and, according to one or more other embodiments, the 1^{st} source/drain pattern 713 and the 2^{nd} source/drain pattern 723 thereabove may be formed at different times to be separated from each other.

The 3D-stacked FET device 60 formed of two NFETs at different levels, and the 3D-stacked FET device 70 formed of two PFETs at different levels may also form a semiconductor device along with one or more different types of FET devices such as those shown in FIGS. 1A-1C, 3A-3B, 4A-4B and 5A-5B, according to one or more embodiments.

In one or more embodiments, a semiconductor device may comprise a plurality of different types of FET devices. Specifically, a semiconductor device may comprise a 1^{st} transistor structure comprising a 1^{st} NFET and a 1^{st} PFET vertically stacked thereabove (such as in the 3D-stacked FET device 10), and a 2^{nd} transistor structure comprising a 2^{nd} PFET and a 2^{nd} NFET vertically stacked thereabove (such as in the 3D-stacked FET device 40). The 1^{st} NFET and the 2^{nd} PFET may have an equal channel width. Likewise, the 1^{st} PFET and the 2^{nd} NFET may have an equal channel width. As described above, the 1^{st} NFET may have a greater number of channel layers 111 than the number of channel layers 121 of the 1^{st} PFET, and the 2^{nd} PFET may have a greater number of channel layers 411 than the number of channel layers 421 of the 2^{nd} NFET. The 1^{st} NFET and the 2^{nd} PFET may have a same number of channel layers 111/411, and the 1^{st} PFET and the 2^{nd} NFET have a same number of channel layers 121/421. The semiconductor device may further comprise a 1^{st} base layer (e.g. the above described base layer 101) on which the 1^{st} transistor structure is disposed and a 2^{nd} base layer (e.g. the above described base layer 401) on which the 2^{nd} transistor structure is disposed, wherein the 1^{st} base layer and the 2^{nd} base layer are connected. In the semiconductor device, the 2^{nd} transistor structure may be disposed at a side of the 1^{st} transistor structure at a same vertical level. The semiconductor device may also comprise a 3^{rd} transistor structure at a side of the 1^{st} transistor structure or the 2^{nd} transistor structure, the 3^{rd} transistor structure comprising a 3^{rd} field-effect transistor (FET) without a transistor vertically thereabove. Examples for such 3^{rd} transistor structure are shown in and described with reference to FIGS 3A/B and FIGS 5A/B. A top surface of a gate electrode of the 3^{rd} transistor structure may be at a same vertical level as a top surface of a gate electrode of the 1^{st} transistor structure or a gate electrode of the 2^{nd} transistor structure. The 3^{rd} FET may be of p-type or n-type. The semiconductor device may comprise a 1^{st} base layer on which the 1^{st} transistor structure is disposed, and a 2^{nd} base layer on which the 2^{nd} transistor structure is disposed, wherein the 3^{rd} FET is disposed on the 1^{st} base layer or the 2^{nd} base layer. The 3^{rd} transistor structure may comprise a channel structure of the 3^{rd} FET surrounded by a 1^{st} work-function metal layer (e.g. the 1^{st} work-function metal layer F31 as described above or the 1^{st} work-function metal layer F51 as described above) of one of p-type and n-type, and wherein a 2^{nd} work-function metal layer (e.g. the 2^{nd} work-function metal layer F32 described above or the 2^{nd} work-function metal layer F52 described above) is formed vertically above the 1^{st} work-function metal layer, the 2^{nd} work-function metal layer being of the other of p-type and n-type. Alternatively to the 3^{rd} transistor structure described above, the semiconductor device may comprise a 3^{rd} transistor structure comprising a 3^{rd} field-effect transistor (FET) and a 4^{th} FET vertically thereabove such as in the 3D-stacked FET devices 60 and 70 described above.

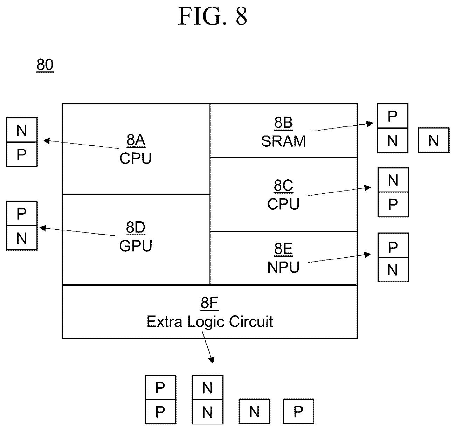

FIG. 8 illustrates such a semiconductor device in which a plurality of different types of FET devices are formed, according to one or more embodiments.

Referring to FIG. 8, a semiconductor device 80 may be formed of a 1^{st} central processing unit (CPU) 8A, an SRAM 8B, a 2^{nd} CPU 8C, a graphic processing unit (GPU) 8D, a neural processing unit (NPU) 8E, and an extra logic circuit 8F formed on one or more base layers, which may each be a silicon substrate and/or a backside isolation structure. The semiconductor device 80 may be implemented by a system-on-chip (SoC), according to one or more embodiments.

The 1^{st} CPU 8A and the 2^{nd} CPU 8C may each include a plurality of 3D-stacked FET devices having the same structure as the 3D-stacked FET device 40 shown in FIGS. 4A and 4B, in which a PFET and an NFET are formed at the 1^{st} level and the 2^{nd} level, respectively.

The CPUs 8A and 8C may require a load balance between high-speed operations and energy efficiency as they perform a variety of tasks, from computationally intensive operations to low-power background processes. Placing the PFET with a greater channel width at the 1^{st} level may enhance power efficiency and better stress control for operations like memory management, while the NFET at the 2^{nd} level may prioritize high-speed operations while consuming less power due to its smaller channel width. Further, when the CPUs 8A and 8C spend a significant amount of time in idle or low power states, placing the greater channel-width PFET at the 1^{st} level may help prevent leakage currents and static power consumption than the greater channel-width NFET at the 1^{st} level.

The SRAM 8B may be formed of a couple of 3D-stacked FET devices in which an NFET and a PFET are formed at the 1^{st} level and the 2^{nd} level thereabove, respectively, which may have the same structure as the 3D-stacked FET device 10 shown in FIGS. 1A-1C, and a couple of NFET devices which have the same structure as the NFET device shown in FIGS. 3A and 3B.

In addition to the advantage of forming NFETs for the two cross-coupled inverters (PD1/PU1 and PD2/PU2) and the pass-gate transistors PG1 and PG2 as shown in FIG. 2 at the same time in a single process, the SRAM 8B including 3D-stacked FET devices having a greater channel-width NFET at the 1^{st} level and the smaller channel-width PFET at the 2^{nd} level may enhance read and write performance of this memory device. For example, the greater channel-width NFET at the 1^{st} level may provide a stronger pull-down capability, which is critical during read operations, to improve read speed, and the smaller channel-width PFET at the 2^{nd} level may balance the pull-up strength, preventing overcompensation during a read operation. As another example, the greater channel-width NFET may ensure better control over a pull-down operation to improve an ability to write a logic value 0 into a memory cell, while the smaller channel-width PFET may prevent excessive drive during the write operation.

The GPU 8D may include a plurality of 3D-stacked FET devices in which an NFET and a PFET are formed at the 1^{st} level and the 2^{nd} level, respectively, which may have the same structure as the 3D-stacked FET device 10 shown in FIGS. 1A-1C.

Considering NFET-dominant performance due to the nature of parallel computation tasks and the need for rapid switching speed, the NFET with a greater channel width at the 1^{st} level and the PFET with a smaller channel width at the 2^{nd} level may align with optimization of the GPU 8D for its compute-intensive roles. As known, GPUs are designed for highly parallel, compute-intensive tasks such as graphics rendering and machine learning. Placing the greater channel-width NFET at the 1^{st} level may allow for maximum current drive and switching speed, prioritizing performance-critical operations for the GPU 8D.

The NPU 8E may include a plurality of 3D-stacked FET devices in which an NFET and a PFET are formed at the 1^{st} level and the 2^{nd} level, respectively, which may have the same structure as the 3D-stacked FET device 10 shown in FIGS. 1A and 1B.

As NPUs are designed for machine learning and artificial intelligence workloads, which involve numerous matrix multiplications and data-parallel computations, these workloads benefit heavily from NFETs with higher current drive and faster switching speed. Thus, forming the NFET with a greater channel width at the 1^{st} level may prioritize these characteristics of NPU 8E to enable faster and more efficient processing.

Further, the extra logic circuit 8F may include one or more of the NFET device 30 of FIGS. 3A and 3B, the PFET device of FIGS. 5A and 5B, and the 3D-stacked FET devices of FIGS. 6A and 6B, and 7A and 7B. The extra logic circuit 8F may form, for example, a memory controller configured to control an external memory device connected to the semiconductor device 80 which may be an SoC.

In the meantime, each of the above-described 3D-stacked FET devices may be manufactured in either a monolithic process or a sequential process, according to one or more other embodiments. In the monolithic process, a 1^{st} FET at the 1^{st} level and a 2^{nd} FET at the 2^{nd} level may be formed from a same substrate to form a 3D-stacked FET device. For example, a plurality of nanosheet layers for a channel structure of the 1^{st} FET and a plurality of nanosheet layers for a channel structure of the 2^{nd} FET may be epitaxially grown in the D3 direction from the same substrate. In contrast, in the sequential process, the 1^{st} FET and the 2^{nd} FET are formed from different substrates and combined by flipping upside down the 1^{st} FET and attaching the flipped 1^{st} FET on to the 2^{nd} FET. For example, the nanosheet layers for the channel structure of the 1^{st} FET and the nanosheet layers for the channel structure of the 2^{nd} FET may be epitaxially grown from different substrates, respectively, before they are combined to form a 3D-stacked FET device.

As another example, a PFET and an NFET stacked thereon to form a 3D-stacked FET device of the 1^{st} CPU 8A may be formed from a same substrate in the monolithic process, in which case, a PFET and an NFET stacked thereon to form a 3D-stacked FET device of the NPU 8E may also be formed from this substrate of the 1^{st} CPU 8A in the same monolithic process. In contrast, the two FETs of the 3D-stacked FET device of the 1^{st} CPU 8A may be formed from different substrates and combined with each other in the sequential process. At this time, however, the PFET of the 3D-stacked FET device of the 1^{st} CPU 8A and the PFET of the 3D-stacked FET device of the NPU 8E may be formed from a same substrate, and the NFET of the 3D-stacked FET device of the 1^{st} CPU 8A and the NFET of the 3D-stacked FET device of the NPU 8E may be formed from another same substrate, so that the pair of the two NFETs are flipped upside down to be combined with the pair of the two PFETs.

When two different substrates, on which respective FET devices are formed, are combined, an interface or a connection surface or mark may be formed between the two substrates. At least one of these substrates may be at least partially replaced by a backside isolation structure to facilitate a backside metal contact structure as described above. When this substrate replacement is performed before two substrates are combined, an interface or a connection surface or mark may also be formed between two backside isolation structures that replace the two substrates. In contrast, when the substrate replacement is performed after combination of the two substrates, no interface or connection surface or mark may be formed in a backside isolation structure replacing the combined substrates.

In the semiconductor device 80, all FETs of the different devices at the 1^{st} level may be disposed at the same level in the D3 direction and may have the same structural shape, and all FETs of the different devices at the 2^{nd} level may be disposed at the same level in the D3 direction and may have the same structural shape. For example, nanosheet layers forming a channel structure of the PFET of the 1^{st} CPU 8A and nanosheet layers forming a channel structure of the NFET of the GPU 8D may be at the same vertical level on respective base layers, and widths of these nanosheet layers in the D2 direction may be the same.

In the above embodiments, a PFET and an NFET are combined to form different types of FET devices depending on the functional purpose of a semiconductor device including the FET devices, for example, CPU, SRAM, GPU, and NPU. However, the disclosure is not limited thereto. According to one or more other embodiments, the PFET and the NFET may be placed differently from those shown in FIG. 8 to form the same CPUs, SRAM, GPU and NPU.

In the above embodiments, all of the FETs formed at the 1^{8t} level or the 2^{nd} level are implemented by a nanosheet transistor. However, the disclosure is not limited thereto, and any other type of FET (e.g., FinFET, forksheet transistor, etc.) may replace any of the nanosheet transistors shown in FIGS. 1A-1C and 3A-3B to 7A-7B, according to one or more other embodiments.

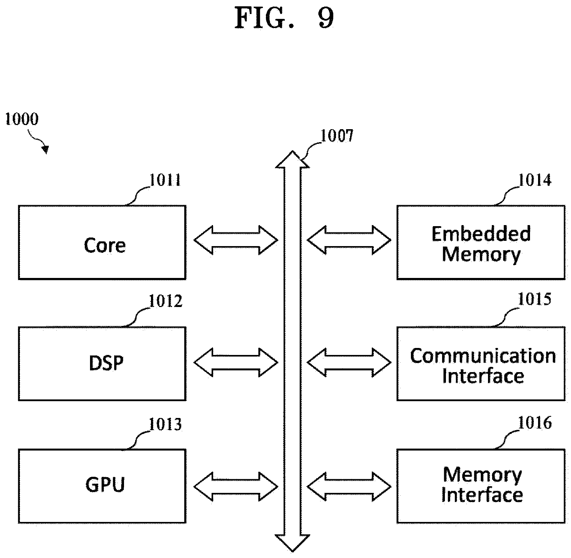

FIG. 9 is a schematic block diagram illustrating an electronic device including one or more semiconductor devices in which a plurality of different types of FET devices are formed, according to one or more embodiments. The semiconductor devices of the electronic device may include one or more of the FET devices shown in3A-3B to 7A-7B, according to one or more embodiments.

Referring to FIG. 9, an SoC 1000 may be an integrated circuit in which components of a computing system or other electronic systems are integrated. As an example of the SoC 1000, an application processor (AP) may include at least one processor and components for various functions. The SoC 1000 may include a core 1011 (e.g., a processor), a digital signal processor (DSP) 1012, a graphic processing unit (GPU) 1013, an embedded memory 1014, a communication interface 1015, and a memory interface 1016. The components of the SoC 1000 may communicate with each other through a bus 1007.

The core 1011 may process instructions and control operations of the components included in the SoC 1000. For example, the core 1011 may process a series of instructions to run an operating system and execute applications on the operating system. The DSP 1012 may generate useful data by processing digital signals (e.g., a digital signal provided from the communication interface 1015). The GPU 1013 may generate data for an image output by a display device from image data provided from the embedded memory 1014 or the memory interface 1016, or may encode the image data.

The embedded memory 1014 may store data necessary for the core 1011, the DSP 1012, and the GPU 1013 to operate. The communication interface 1015 may provide an interface for a communication network or one-to-one communication. The memory interface 1016 may provide an interface for an external memory of the SoC 1000, such as a dynamic random access memory (DRAM), a flash memory, etc.

At least one of the core 1011, the DSP 1012, the GPU 1013, and/or the embedded memory 1014 may include one or more of the FET devices shown in FIGS. 1A-1C, 3A-3B to 7A-7B, according to one or more embodiments.

The foregoing is illustrative of example embodiments and is not to be construed as limiting the disclosure. Although a few example embodiments have been described, those skilled in the art will readily appreciate that many modifications are possible in the above embodiments without materially departing from the disclosure.

## Claims

1. A semiconductor device comprising:
a 1^{st} transistor structure comprising a 1^{st} n-type field-effect transistor, NFET, and a 1^{st} p-type field-effect transistor, PFET, vertically thereabove, the 1^{st} NFET having a greater channel width than the 1^{st} PFET, and
a 2^{nd} transistor structure comprising a 2^{nd} PFET and a 2^{nd} NFET vertically thereabove, the 2^{nd} PFET having a greater channel width than the 2^{nd} NFET.

2. The semiconductor device of claim 1, wherein the 1^{st} NFET and the 2^{nd} PFET have an equal channel width.

3. The semiconductor device of claim 1 or 2, wherein the 1^{st} PFET and the 2^{nd} NFET have an equal channel width.

4. The semiconductor device of any one of claims 1 to 3,
wherein the 1^{st} NFET has a greater number of channel layers (111) than the 1^{st} PFET, and
wherein the 2^{nd} PFET has a greater number of channel layers (411) than the 2^{nd} NFET.

5. The semiconductor device of any one of claims 1 to 4,
wherein the 1^{st} NFET and the 2^{nd} PFET have a same number of channel layers (111, 411), and
wherein the 1^{st} PFET and the 2^{nd} NFET have a same number of channel layers (121, 421).

6. The semiconductor device of any one of claims 1 to 5,
wherein the 1^{st} PFET partially overlaps the 1^{st} NFET in a vertical direction (D3), and
wherein the 2^{nd} NFET partially overlaps the 2^{nd} PFET in the vertical direction (D3).

7. The semiconductor device of any one of claims 1 to 6, further comprising:
a 1^{st} base layer (101) on which the 1^{st} transistor structure is disposed; and
a 2^{nd} base layer (401) on which the 2^{nd} transistor structure is disposed,
wherein the 1^{st} base layer (101) and the 2^{nd} base layer (401) are connected.

8. The semiconductor device of any one of claims 1 to 7, wherein the 2^{nd} transistor structure is disposed at a side of the 1^{st} transistor structure at a same vertical level.

9. The semiconductor device of any one of claims 1 to 8, further comprising:
a 3^{rd} transistor structure at a side of the 1^{st} transistor structure or the 2^{nd} transistor structure, the 3^{rd} transistor structure comprising a 3^{rd} field-effect transistor, FET, without a transistor vertically thereabove.

10. The semiconductor device of claim 9, wherein a top surface of a gate electrode (GE3; GE4) of the 3^{rd} transistor structure is at a same vertical level as a top surface of a gate electrode (GE1) of the 1^{st} transistor structure or a gate electrode (GE2) of the 2^{nd} transistor structure.

11. The semiconductor device of claim 9 or 10, wherein the 3^{rd} FET is of p-type or n-type.

12. The semiconductor device of any one of claims 9 to 11, further comprising:
a 1^{st} base layer (101) on which the 1^{st} transistor structure is disposed; and
a 2^{nd} base layer (401) on which the 2^{nd} transistor structure is disposed,
wherein the 3^{rd} FET is disposed on the 1^{st} base layer (101) or the 2^{nd} base layer (401).

13. The semiconductor device of any one of claims 9 to 12, wherein the 3^{rd} transistor structure comprises a channel structure of the 3^{rd} FET surrounded by a 1^{st} work-function metal layer (F31; F51) of one of p-type and n-type, and
wherein a 2^{nd} work-function metal layer (F32; F52) is formed vertically above the 1^{st} work-function metal layer (F31; F51), the 2^{nd} work-function metal layer (F32; F52) being of the other of p-type and n-type.

14. The semiconductor device of any one of claims 1 to 13, further comprising:
a 3^{rd} transistor structure comprising a 3^{rd} field-effect transistor, FET, and a 4^{th} FET vertically thereabove,
wherein both of the 3^{rd} FET and the 4^{th} FET are of p-type or n-type.

15. A semiconductor device comprising:
a 1^{st} transistor structure comprising a 1^{st} field-effect transistor, FET, and a 2^{nd} FET vertically above the 1^{st} FET, the 1^{st} FET having a greater channel width than the 2^{nd} FET; and
a 2^{nd} transistor structure comprising a 3^{rd} FET without a transistor vertically thereabove,
wherein the 3^{rd} FET is disposed at a side of the 1^{st} FET at a same vertical level.
